# EUROPÄISCHE PATENTSCHRIFT

(11) **EP 2 801 873 B1**
(45) Veröffentlichungstag und Bekanntmachung des Hinweises auf die Patenterteilung: **13.06.2018**
(21) Anmeldenummer: 14153755.5
(22) Anmeldetag: 04.02.2014
(51) Int. Cl.: G05B 17/02

(54) **Testeinrichtung zum Test eines virtuellen Steuergeräts**
Test device for testing a virtual control device
Dispositif de test d'un appareil de commande virtuel

(30) Priorität: 06.05.2013 EP 13166604
(43) Veröffentlichungstag der Anmeldung: 12.11.2014
(73) Patentinhaber: dSPACE digital signal processing and control engineering GmbH, 33102 Paderborn (DE)
(72) Erfinder: Franzen, Dr. Ortwin Ludger, 33175 Bad Lippspringe (DE); Krügel, Dr. Karsten, 33106 Paderborn (DE)

(56) Entgegenhaltungen:
- EP-A2- 1 291 742
- US-A1- 2009 240 477
- US-A1- 2010 100 365
- US-A1- 2012 143 518
- Suguna Thanagasundram ET AL: "Contributed Paper: Reconfigurable Hardware-in-the-loop Simulator", , 30. November 2010 (2010-11-30), Seiten 273-277, XP055133639, Gefunden im Internet: URL:http://www.researchgate.net/profile/Su guna_Thanagasundram/publication/231582186_ Reconfigurable_Hardware-_in-the-loop_Simul ator/file/9fcfd506cf18980d6d.pdf [gefunden am 2014-08-06]

## Beschreibung

Die Erfindung betrifft eine Testeinrichtung zum Test zumindest eines Teils eines virtuellen Steuergeräts mit einer Simulationsumgebung in einem Simulator, aufweisend das virtuelle Steuergerät und die Simulationsumgebung, wobei das virtuelle Steuergerät wenigstens eine Software-Komponente mit wenigstens einer äußeren Datenschnittstelle umfasst, wobei die Simulationsumgebung wenigstens eine Datenschnittstelle zum zumindest mittelbaren Datenaustausch mit dem virtuellen Steuergerät umfasst.

Unter nicht-virtuellen, also "realen" Steuergeräten werden heutzutage zumeist Kleinrechner mit einer I/O-Schnittstelle (I/O = Input/Output) verstanden, die oft mit einem echtzeitfähigen Betriebssystem ausgestattet sind, das die Realisierung - auch komplexer - zumeist regelungstechnischer Aufgaben auf dem Steuergerät gestattet. Die Steuergeräte-Entwicklung ist zentraler Bestandteil der technischen Entwicklung von umfangreichen gerätetechnischen Anlagen, wie sie aus der industriellen Praxis bekannt sind. Beispielhaft zu nennen ist der Einsatz von Steuergeräten im automotiven Bereich und in der Luft- und Raumfahrt. Das Dokument "Reconfigurable Hardware-in-the-loop Simulator" (Suguna Thanagasundram und Ross McMurran) offenbart eine Simulationsumgebung zur Steuergeräte-Entwicklung. Der Test des im Endprodukt zum Einsatz kommenden Serien-Steuergeräts ist der Endpunkt einer Mehrzahl vorgelagerter Entwicklungsschritte einer auf dem Steuergerät zu implementierenden Regelung oder Steuerung, wobei diese Entwicklungsschritte üblicherweise mit dem sogenannten V-Modell oder auch V-Zyklus beschrieben werden. Am Anfang der für die Funktion vieler technischer Anlagen essentiellen Reglerentwicklung steht die mathematische Modellierung des Regelungsalgorithmus auf einem Rechner mit einer mathematisch-graphischen Modellierungsumgebung, wobei der Regler als Bestandteil des Steuergeräts aufzufassen ist. Zusätzlich wird auch die Umgebung des Steuergeräts mathematisch modelliert, da die Interaktion des Reglers auf dem Steuergerät mit dem zu steuernden Prozess von Interesse ist. Bei diesen funktionalen mathematischen Betrachtungen ist eine Simulation in Echtzeit meist nicht erforderlich (Offline-Simulation).
Im nächsten Schritt wird der zuvor entworfene Regelungsalgorithmus mit Hilfe des Rapid-Control-Prototyping auf eine leistungsfähige, meist echtzeitfähige Hardware übertragen, die über geeignete I/O-Schnittstellen mit dem tatsächlichen physikalischen Prozess verbunden ist, also beispielsweise mit einem Kraftfahrzeug-Motor. Diese echtzeitfähige Hardware hat mit dem später zum Einsatz kommenden Serien-Steuergerät im Regelfall nichts zu tun, es geht hier um den Nachweis der prinzipiellen Funktionsfähigkeit der zuvor entworfenen Regelung in der Praxis.

In einem weiteren Schritt wird im Rahmen der automatischen Seriencodegenerierung die Regelung auf dem später im Serien-Steuergerät wahrscheinlich tatsächlich zum Einsatz kommenden Zielprozessor implementiert. Die Zielhardware nähert sich demnach in diesem Schritt dem Serien-Steuergerät an, ist mit dem Serien-Steuergerät aber nicht identisch. In einem weiteren Schritt wird das üblicherweise erst in einem späten Entwicklungsstadium vorhandene Serien-Steuergerät im Rahmen eines Hardware-in-the-Loop-Tests (HIL) überprüft. Das in diesem Schritt physikalisch vorhandene Serien-Steuergerät wird hier mittels seiner physikalischen Steuergeräteschnittstelle mit einem leistungsfähigen Simulator verbunden. Der Simulator simuliert die benötigten Größen des zu testenden Serien-Steuergeräts und tauscht Ein- und Ausgangsgrößen mit dem Serien-Steuergerät aus. Die Pins der physikalischen Steuergeräte-Schnittstelle des Serien-Steuergeräts sind über einen Kabelbaum mit dem Simulator verbunden. So ist es möglich, in der Simulationsumgebung alle benötigten Größen eines Kraftfahrzeug-Motors - gegebenenfalls das gesamte Kraftfahrzeug mit Motor, Antriebstrang, Fahrwerk und Fahrstrecke - zu simulieren und das Verhalten des Serien-Steuergeräts im Zusammenspiel mit der Simulationsumgebung gefahrlos zu überprüfen.

Das so im Rahmen der HIL-Simulation getestete Serien-Steuergerät wird letztendlich in dem "echten" Zielsystem, also beispielsweise in einem Kraftfahrzeug verbaut und in der echten physikalischen Umgebung getestet, die zuvor in der Simulationsumgebung nur vorgetäuscht worden ist.

Der zuvor skizzierte Entwicklungsprozess bei der Reglerentwicklung hat sich außerordentlich bewährt. Der Entwicklungsprozess bringt es jedoch mit sich, dass das Serien-Steuergerät erst ganz am Ende der Entwicklung in den Entwicklungsprozess eingebunden wird und damit auch erst in späten Entwicklungsständen überprüft wird. Bevor das Serien-Steuergerät tatsächlich vorliegt, können mit dem aufgezeigten Entwicklungsprozess nur Funktionalitäten auf abstrakter funktioneller Ebene getestet werden, also praktisch nur auf der Ebene der Applikationssoftware. Ein guter Teil der später auf dem Serien-Steuergerät zum Einsatz kommenden Software-Komponenten wird in frühen Entwicklungsständen nicht mitgetestet. Zu diesen Software-Komponenten gehört beispielsweise das Runtime-Environment, das zwischen der Applikationssoftware und den hardwarenahen Softwareschichten vermittelt. Hardwarenähere Softwarekomponenten sind beispielsweise das Betriebssystem und plattform-unabhängige Basissoftware (Systemdienste, Kommunikationsdienste, I/O-Hardware-Abstraktionsschicht usw.) und schließlich plattformabhängige Teile des Betriebssystems und der Basissoftware.

Neben den zuvor beschriebenen Anteilen eines Serien-Steuergeräts, die erst recht spät im Entwicklungsprozess einer Prüfung unterzogen werden können, gibt es auch Kategorien von Tests, die typischerweise erst am realen Steuergerät durchgeführt werden können, hierbei handelt es sich um die elektrische Fehlersimulation bei realen Steuergeräten. Im Rahmen dieser Fehlersimulation ist es zum Beispiel möglich, durch geeignete Hardware, mit der das zu testende Steuergerät verbunden ist, Steuergeräte-Pins auf ein bestimmtes elektrisches Potential zu legen, beispielsweise auf Masse oder die Versorgungsspannung, Verbindungen zwischen Steuergeräte-Pins und ihrer externen Beschaltung aufzutrennen ("broken wire") bzw. die Verbindung mit einem Widerstand zu beaufschlagen, Steuergeräte-Pins miteinander zu verbinden (Kurzschluss zwischen Steuergeräte-Pins) und Verdrahtungen zwischen verschiedenen Steuergeräte-Pins zu vertauschen ("crossed wire") usw. (dSPACE-Katalog 2013, Seite 268, Seiten 280 ff. und Seiten 459 ff.). Selbstverständlich können derartige Fehlerfälle kombiniert werden, so dass das zu testende Steuergerät letztendlich auch in Situationen beobachtet werden kann, wenn mehrere Fehler im externen elektrischen Anschluss vorliegen. Um das Schalten von Fehlern zu vereinfachen, können im Simulator oder außerhalb des Simulators sogenannte "fail rails" verwendet werden, also elektrische Leitungen, die Träger eines bestimmten elektrischen Fehlersignals sind und auf die dann die mit dem entsprechenden Fehler zu beaufschlagenden Steuergeräte-Pins aufgeschaltet werden können. Die bislang beschriebene elektrische Fehlersimulation ist nur möglich, wenn das zu testende Steuergerät hardwaremäßig vorliegt und damit auch die realen Steuergeräte-Pins physikalisch beschaltet werden können. Liegt lediglich ein virtuelles Steuergerät vor, dann bleibt lediglich die Möglichkeit, zur Simulation von elektrischen Fehlern den vorhandenen Steuergerätecode zu instrumentieren, um von dort aus eine Fehlereinstreuung zu implementieren (EP 2 672 660 A1), dieses Verfahren ist aufwendig und ggf. ist die Instrumentierung der Software an variierende äußere Datenschnittstellen des virtuellen Steuergeräts anzupassen. Insgesamt wäre es wünschenswert, eine pinbasierte elektrische Fehlersimulation durchführen zu können, bevor das reale Serien-Steuergerät vorliegt. Weiterhin wäre es wünschenswert, die gleichen Konfigurationen, Simulationsmodelle und Tests sowohl beim Testen eines virtuellen Steuergeräts als auch beim Testen eines Serien-Steuergeräts wiederverwenden zu können.

Um die zuvor genannten umfangreichen Software-Komponenten des Serien-Steuergeräts (Runtime-Environment, Systemdienste, Kommunikationsdienste, I/O-Hardware-Abstraktionsschicht usw.) frühzeitig in den Entwicklungsprozess einzubeziehen, werden die zuvor genannten Software-Komponenten - zumindest teilweise - im Rahmen eines sogenannten virtuellen Steuergeräts nachgebildet und in einem Simulator simuliert (dSPACE Catalog 2013: "SystemDesk V-ECU Generation Module" und "VEOS"). Bei dem Simulator kann es sich um einen oder mehrere spezialisierte Rechner handeln, beispielsweise in Form eines HIL-Teststandes, als Simulator kann aber auch ein handelsüblicher PC zum Einsatz kommen. In dem Simulator interagiert jedenfalls das virtuelle Steuergerät mit der ebenfalls in dem Simulator vorhandenen Simulationsumgebung. Die Interaktion geschieht durch Austausch von Daten über die wenigstens eine äußere Datenschnittstelle einer Software-Komponente des virtuellen Steuergeräts und eine Datenschnittstelle der Simulationsumgebung. Welche Software-Komponenten des virtuellen Steuergeräts eine äußere Datenschnittstelle zur Verfügung stellen, hängt davon ab, welche der zuvor genannten Software-Schichten in dem virtuellen Steuergerät abgebildet werden. Wenn in dem virtuellen Steuergerät lediglich die abstrakte Applikationssoftware abgebildet ist, dann stellen die Software-Komponenten der Applikationssoftware die äußeren Datenschnittstellen zur Simulationsumgebung. Wenn dagegen zusätzlich auch das Runtime-Environment Bestandteil des virtuellen Steuergeräts ist, werden die äußeren Datenschnittstellen durch deren Software-Komponenten zur Verfügung gestellt. Wenn noch tiefer liegende Softwareschichten abgebildet werden, beispielsweise des Betriebssystems oder Basissoftwarekomponenten, dann stellen diese Software-Komponenten die äußere Datenschnittstelle zur Simulationsumgebung.

Es ist erkennbar, dass die Simulationsumgebung sich jeweils an die äußere Datenschnittstelle der Software-Komponenten des virtuellen Steuergeräts anpassen muss in Abhängigkeit von den in dem virtuellen Steuergerät nachgebildeten Software-Komponenten. Jede Änderung des virtuellen Steuergeräts, die eine Software-Komponente mit einer äußeren Datenschnittstelle betrifft, zieht unweigerlich auch eine Änderung der Simulationsumgebung und der Datenschnittstelle der Simulationsumgebung nach sich, was arbeitsintensiv ist und Fehlerquellen im Entwicklungsprozess mit sich bringt. Nachteilig ist auch, dass die auf ein bestimmtes virtuelles Steuergerät angepasste Simulationsumgebung im Rahmen der HIL-Simulation - also wenn das Steuergerät physikalisch vorhanden ist und nicht mehr nur virtuell vorliegt - häufig nicht unmittelbar verwendet werden kann, da die für eine solche Verwendung erforderliche Bereitstellung von pinbezogenen Größen der physikalischen Steuergeräteschnittstelle an der Datenschnittstelle der Simulationsumgebung nicht gegeben ist. Dieser Umstand verhindert praktisch auch eine praktikable Realisierung der zuvor angesprochenen elektrischen Fehlersimulation im Zusammenhang mit virtuellen Steuergeräten.

Es ist daher Aufgabe der vorliegenden Erfindung, eine Einrichtung zum Test zumindest eines Teils eines virtuellen Steuergeräts mit einer Simulationsumgebung in einem Simulator zur Verfügung zu stellen, bei der die Abhängigkeiten zwischen dem virtuellen Steuergerät und der Simulationsumgebung reduziert werden, so dass insbesondere auch eine elektrische Fehlersimulation mit virtuellen Steuergeräten auf einfacherem Wege möglich ist.

Die zuvor hergeleitete Aufgabe wird bei der eingangs beschriebenen Testeinrichtung zunächst und im Wesentlichen dadurch gelöst, dass die Testeinrichtung durch eine virtuelle Steuergeräte-Pin-Einheit ergänzt wird, die wenigstens eine virtuelle Steuergeräteschnittstelle aufweist und mittels der virtuellen Steuergeräteschnittstelle zumindest mit der äußeren Datenschnittstelle der Software-Komponente des virtuellen Steuergeräts verbunden ist. Darüber hinaus weist die virtuelle Steuergeräte-Pin-Einheit wenigstens eine Simulationsumgebungsschnittstelle auf, wobei die virtuelle Steuergeräte-Pin-Einheit mittels der Simulationsumgebungsschnittstelle zumindest mittelbar mit der Datenschnittstelle der Simulationsumgebung verbunden ist. Darüber hinaus ist vorgesehen, dass die virtuelle Steuergeräte-Pin-Einheit wenigstens einen virtuellen Steuergeräte-Pin aufweist, der mit einem Pin der physikalischen Schnittstelle eines zu simulierenden realen Steuergeräts korrespondiert, wobei über den virtuellen Steuergeräte-Pin ein virtuelles physikalisches Steuergerätesignal übertragbar ist, das in Datenform die physikalischen Steuergerätesignale an dem korrespondierenden Pin der physikalischen Schnittstelle beschreibt. Durch die Zurverfügungstellung eines virtuellen Steuergeräte-Pins wird ein virtuelles Abbild des korrespondierenden realen Steuergeräte-Pins der physikalischen Schnittstelle des zu simulierenden Steuergeräts geschaffen. Dies ist in Zusammenhang mit der erfindungsgemäßen Maßnahme von Vorteil, die vorsieht, dass eine virtuelle Beeinflussungs-Einheit wenigstens eine erste Schnittstelle und eine zweite Schnittstelle aufweist, wobei die virtuelle Beeinflussungs-Einheit mittels der ersten Schnittstelle zumindest mit dem virtuellen Steuergeräte-Pin der Steuergeräte-Pin-Einheit verbunden ist und mit der zweiten Schnittstelle mit der Datenschnittstelle der Simulationsumgebung verbunden ist, wobei die virtuelle Beeinflussungs-Einheit über die erste Schnittstelle und/oder die zweite Schnittstelle ein beeinflusstes virtuelles physikalisches Steuergerätesignal ausgibt. Die beiden wesentlichen Punkte der erfindungsgemäßen Testeinrichtung liegen also in der virtuellen Steuergeräte-Pin-Einheit, die wenigstens einen virtuellen Steuergeräte-Pin zur Verfügung stellt, der mit einem Pin der physikalischen Schnittstelle eines zu simulierenden realen Steuergeräts korrespondiert und in der Zurverfügungstellung der virtuellen Beeinflussungs-Einheit, die vollkommen korrespondierend mit dem Anschluss von hardwaremäßigen Fehlerschaltungen an physikalische Steuergeräte-Pins echter zu testender Steuergeräte mit den korrespondierenden virtuellen Steuergeräte-Pins der virtuellen Steuergeräte-Pin-Einheit verbunden werden kann.

Die erfindungsgemäß vorgesehene virtuelle Steuergeräte-Pin-Einheit vermittelt zwischen dem virtuellen Steuergerät und der Simulationsumgebung, was grundsätzlich die Möglichkeit eröffnet, die Simulationsumgebung und deren Datenschnittstelle auch bei einer Veränderung des virtuellen Steuergeräts unverändert zu lassen. Die zusätzliche Zurverfügungstellung eines virtuellen Steuergeräte-Pins bringt darüber hinaus die Möglichkeit mit sich, das virtuelle Abbild jener Schnittstelle zu definieren, die das reale Steuergerät zwingend auch aufweisen muss, nämlich der physikalischen Schnittstelle des realen Steuergeräts. Dies eröffnet auf dem Simulator eine pinbezogene Definition und Handhabung der Schnittstelle zwischen dem virtuellen Steuergerät und der Simulationsumgebung.

Die über einen virtuellen Steuergeräte-Pin der virtuellen Steuergeräte-Pin-Einheit ausgetauschten Informationen sind insoweit ein "virtuelles physikalisches Steuergerätesignal", als dass es sich hier zwar nicht um die echten physikalischen Steuergerätesignale des realen Steuergerätes handelt, also um Spannungen, Ströme, Anschlusswiderstände, aber diese physikalischen Größen werden berechnet und wertemäßig als entsprechende Daten ausgetauscht. Mit anderen Worten beschreibt ein virtuelles physikalisches Steuergerätesignal in Datenform die physikalischen Steuergerätesignale an dem korrespondierenden Pin der physikalischen Schnittstelle. Wenn in dem virtuellen Steuergerät nur abstraktere Softwareschichten abgebildet sind, also beispielsweise die Applikationssoftware oder das Runtime-Environment, dann kann die äußere Datenschnittstelle des virtuellen Steuergeräts nur abstrakt funktional sein, aber keine signalmäßige Nachbildung des echten Steuergeräts liefern. Falls beispielsweise von einer Komponente der Applikationssoftware ein Druckwert oder ein Temperaturwert geliefert wird (zum Beispiel 950 bar, 275 °C) aber keine entsprechende elektrisch codierte Größe, die bei dem realen Steuergerät über Pins der physikalischen Schnittstelle ausgetauscht wird, beispielsweise in Form einer Spannung (z. B. 0 bis 10 V), in Form eines Stromes (z. B. 2 bis 20 mA-Schnittstelle) oder in Form eines modulierten Signals, kann die virtuelle Steuergeräte-Pin-Einheit diese Lücke nunmehr schließen, indem sie an wenigstens einen virtuellen Steuergeräte-Pin genau ein solches virtuelles physikalisches Steuergerätesignal, also den Wert des entsprechenden realen physikalischen Steuergerätesignals, überträgt. Selbstverständlich ist auch die zum vorigen Beispiel umgekehrte Signalflussrichtung möglich, indem beispielsweise ein virtuelles physikalisches Steuergerätesignal von dem virtuellen Steuergeräte-Pin abgerufen und in Richtung auf das virtuelle Steuergerät hin übertragen wird.

Erfindungsgemäß ist vorgesehen, dass die virtuelle Beeinflussungs-Einheit über eine ihrer Schnittstellen ein beeinflusstes virtuelles physikalisches Steuergerätesignal ausgibt, weshalb die virtuelle Beeinflussungs-Einheit auch grundsätzlich über die Fähigkeit verfügt, ein virtuelles physikalisches Steuergerätesignal zu beeinflussen, üblicherweise im Sinne der Nachbildung eines elektrischen Fehlerfalls. In einem Ausführungsbeispiel der Testeinrichtung ist beispielsweise vorgesehen, dass die Beeinflussungs-Einheit ein beeinflusstes virtuelles physikalisches Steuergerätesignal selbständig bereitstellt, beispielsweise weil der Nutzer entsprechende Konfigurationsdaten in der Beeinflussungs-Einheit hinterlegt hat. Eine solche Konfiguration könnte beispielsweise darin bestehen, dass ein bestimmter Anschluss der ersten Schnittstelle und/oder der zweiten Schnittstelle der virtuellen Beeinflussungs-Einheit fest auf das elektrische Masse-Potential gelegt ist. In diesem Fall werden keine weiteren Informationen zur Ermittlung des beeinflussten virtuellen physikalischen Steuergerätesignals benötigt, insbesondere keine Informationen aus der Simulationsumgebung. Eine elektrische Fehlersimulation kann dann darin bestehen, dass das vorgegebene und daher auch beeinflusste virtuelle physikalische Steuergerätesignal über die erste Schnittstelle der Beeinflussungs-Einheit an die virtuelle Steuergeräte-Pin-Einheit übertragen wird.

Die Beeinflussungs-Einheit kann auch über ihre Schnittstellen mit mehr als einem virtuellen Steuergeräte-Pin der virtuellen Steuergeräte-Pin-Einheit verbunden sein. Es ist dann natürlich nicht erforderlich, dass über jeden dieser Anschlüsse ein beeinflusstes virtuelles physikalisches Steuergerätesignal ausgegeben bzw. übertragen wird, mit anderen Worten, es muss nicht jeder Kanal von der virtuellen Beeinflussungs-Einheit tatsächlich auch beeinflusst werden, es können virtuelle physikalische Steuergerätesignale beispielsweise auch unbeeinflusst übertragen werden.

Der große Vorteil der erfindungsgemäßen Testeinrichtung liegt darin, dass eine vollständige Durchgängigkeit hinsichtlich der Konfiguration, Simulation und dem Test erzielt wird zwischen der Fehlersimulation bei realen Steuergeräte und der Fehlersimulation bei virtuellen Steuergeräten. Aufgrund der pinorientierten Ausgestaltung der Schnittstellen kann die Simulationsumgebung - jedenfalls insoweit sie über virtuelle Steuergeräte-Pins der virtuellen Steuergeräte-Pin-Einheit kommuniziert - ohne weitere Anpassung verwendet werden mit dem hardwaremäßig realisierten Serien-Steuergerät. Hinsichtlich der denkbaren Ausführungsbeispiele und Ausgestaltungen der virtuellen Steuergeräte-Pin-Einheit werden zahlreiche Varianten in der prioritätsbegründenden Anmeldung EP 13/166604 beschrieben. So ist beispielsweise vorgesehen, dass die Simulationsumgebungsschnittstelle der virtuellen Steuergeräte-Pin-Einheit zumindest einen virtuellen Steuergeräte-Pin aufweist, so dass über die Datenschnittstelle der Simulationsumgebung auch virtuelle physikalische Steuergerätesignale übertragbar sind. Bei einer Weiterbildung der Testeinrichtung ist ferner vorgesehen, dass die Simulationsumgebungsschnittstelle der virtuellen Steuergeräte-Pin-Einheit vollständig aus virtuellen Steuergeräte-Pins gebildet ist, so dass über die Datenschnittstelle der Simulationsumgebung ausschließlich virtuelle physikalische Steuergerätesignale übertragen werden. In einer anderen Variante ist vorgesehen, dass die Simulationsumgebungsschnittstelle der virtuellen Steuergeräte-Pin-Einheit keinen virtuellen Steuergeräte-Pin aufweist, so dass die virtuelle Steuergeräte-Pin-Einheit eine direkte Verbindung zwischen dem virtuellen Steuergerät und der Simulationsumgebung herstellt und die virtuelle Steuergeräte-Pin-Einheit den wenigstens einen virtuellen Steuergeräte-Pin außerhalb der Simulationsumgebungsschnittstelle aufweist. Diese Varianten und deren Mischformen sind in den prioritätsbegründenden Anmeldungsunterlagen im Detail beschrieben, insoweit wird auf die dortigen detaillierten Ausführungen verwiesen.

Gemäß einer Weiterbildung der erfindungsgemäßen Testeinrichtung ist hinsichtlich der virtuellen Beeinflussungs-Einheit vorgesehen, dass die Beeinflussungs-Einheit auf Grundlage von Informationen aus der Simulationsumgebung ein beeinflusstes virtuelles physikalisches Steuergerätesignal berechnet und über die erste Schnittstelle an die virtuelle Steuergeräte-Pin-Einheit überträgt. Es sind natürlich auch Mischformen zwischen dieser Variante der Berechnung von beeinflussten virtuellen physikalischen Steuergerätesignalen möglich, d. h. ein beeinflusstes virtuelles physikalisches Steuergerätesignal kann in der Beeinflussungs-Einheit festgelegt sein - es bedarf also keiner Informationen aus der Simulationsumgebung zur Berechnung dieses beeinflussten virtuellen physikalischen Steuergerätesignals - und ein anderes beeinflusstes virtuelles physikalisches Steuergerätesignal kann unter Nutzung von Informationen aus der Simulationsumgebung oder auch aus dem virtuellen Steuergerät in der Beeinflussungs-Einheit berechnet werden.

Bei einer Weiterbildung der Testeinrichtung ist vorgesehen, dass die Beeinflussungs-Einheit von der virtuellen Steuergeräte-Pin-Einheit ein virtuelles physikalisches Steuergerätesignal empfängt und aus dem empfangenen virtuellen physikalischen Steuergerätesignal ein beeinflusstes virtuelles physikalisches Steuergerätesignal berechnet, insbesondere das beeinflusste virtuelle physikalische Steuergerätesignal über die zweite Schnittstelle an die Simulationsumgebung ausgibt. In diesem Fall liegt also kein elektrischer Fixfehler vor, vielmehr wird eine Eingangsgröße gemäß einer bestimmten Funktionalität beeinflusst und beeinflusst weitergegeben. Denkbar ist beispielsweise die verfälschte Weitergabe eines Spannungswertes aufgrund eines - möglicherweise nichtlineare Elemente aufweisenden - simulierten Spannungsteilers.

Gemäß einer besonders bevorzugten Weiterbildung der Testeinrichtung ist vorgesehen, dass die virtuelle Beeinflussungseinheit der virtuellen Steuergeräte-Pin-Einheit und der Simulationsumgebung zwischengeschaltet ist, so dass eine mittelbare Verbindung mit der äußeren Datenschnittstelle der Software-Komponente des virtuellen Steuergeräts besteht und/oder so dass eine Verbindung mit den Teilen der Datenschnittstelle der Simulationsumgebung hergestellt ist, die mit der äußeren Datenschnittstelle der Software-Komponente des virtuellen Steuergeräts korrespondieren. In diesem Ausführungsbeispiel laufen alle Signale über die virtuelle Beeinflussungs-Einheit, also nicht nur die Signale, die über virtuelle Steuergeräte-Pins der virtuellen Steuergeräte-Pin-Einheit vermittelt werden. Die virtuelle Beeinflussungs-Einheit verfügt damit nicht nur über die pinorientierten Signale, sondern vielmehr auch über funktionale Signale, die zwischen der äußeren Datenschnittstelle der Software-Komponenten des virtuellen Steuergeräts und der Simulationsumgebung ausgetauscht werden. Diese Variante ermöglicht in bestimmten Fällen eine effizientere Simulation, insbesondere eine effizientere Fehlersimulation innerhalb der virtuellen Beeinflussungs-Einheit.

Im Einzelnen gibt es nun eine Vielzahl von Möglichkeiten, die erfindungsgemäße Testeinrichtung auszugestalten und weiterzubilden. Dazu wird auf die dem Patentanspruch 1 nachgeordneten Patentansprüche sowie auf die nachfolgende Beschreibung bevorzugter Ausführungsbeispiele der Erfindung unter Bezugnahme auf die Zeichnung verwiesen. In der Zeichnung zeigen
- Fig. 1: einen aus dem Stand der Technik bekannten Testaufbau zum Test eines realen Steuergeräts mit einem Simulator,
- Fig. 2: eine aus dem Stand der Technik bekannte Testeinrichtung zum Test eines virtuellen Steuergeräts mit einer Simulationsumgebung,
- Fig. 3: ein erstes Ausführungsbeispiel für eine erfindungsgemäße Testeinrichtung zum Test eines virtuellen Steuergeräts mit einer virtuellen Steuergeräte-Pin-Einheit und einer virtuellen Beeinflussungs-Einheit,
- Fig. 4: ein weiteres Ausführungsbeispiel für eine erfindungsgemäße Testeinrichtung zum Test eines virtuellen Steuergeräts mit einer virtuellen Steuergeräte-Pin-Einheit und einer virtuellen Beeinflussungs-Einheit,
- Fig. 5: ein weiteres Ausführungsbeispiel für eine erfindungsgemäße Testeinrichtung ausgehend von dem Ausführungsbeispiel gemäß Fig. 4,
- Fig. 6: ein weiteres Ausführungsbeispiel für eine erfindungsgemäße Testeinrichtung mit einer kombinierten virtuellen Steuergeräte-Pin-Einheit und einer virtuellen Beeinflussungs-Einheit und
- Fig. 7: ein letztes Ausführungsbeispiel für eine erfindungsgemäße Testeinrichtung mit einer detailliert dargestellten Realisierung der virtuellen Beeinflussungs-Einheit.

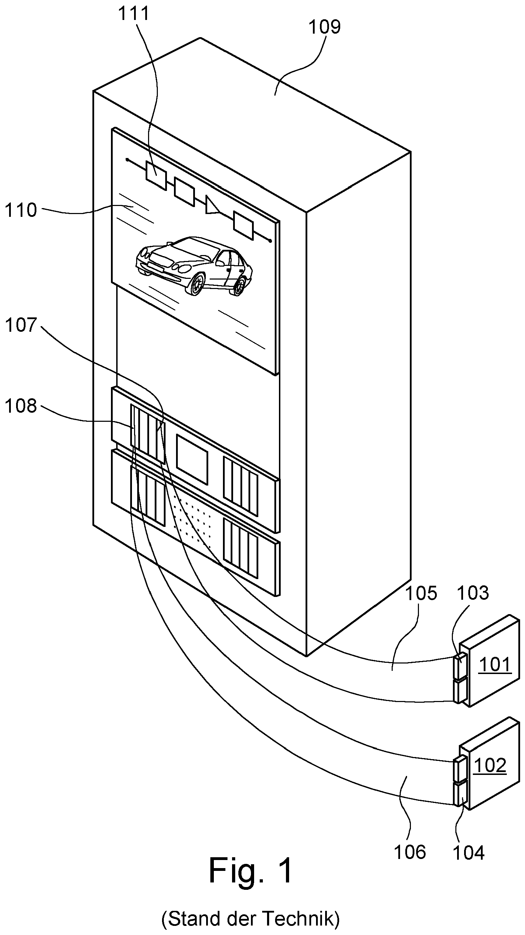

Zur Erläuterung der erfindungsgemäßen Testeinrichtung ist in Fig. 1 zunächst ein aus dem Stand der Technik bekannter Testaufbau nach dem Prinzip des Hardware-in-the-Loop-Tests dargestellt. In dem dargestellten Testaufbau kommen keine virtuellen Steuergeräte vor, Gegenstand des Tests sind die realen Steuergeräte 101, 102. Die realen Steuergeräte 101, 102 sind mit ihren physikalischen Schnittstellen 103, 104 und über Kabelbäume 105, 106 mit entsprechenden I/O-Schnittstellen 107, 108 eines Simulators 109 verbunden. Der Simulator 109 selbst weist neben den I/O-Schnittstellen 107, 108 auch eine Simulationsumgebung 110 auf, die ein mathematisches Umgebungsmodell zum Gegenstand hat, welches die Umgebung des Steuergerätes simuliert, z.B. ein Fahrzeugmodell. Das Umgebungsmodell ist angedeutet durch das Blockschaltbild 111. Der in Fig. 1 dargestellte Testaufbau ergibt sich erst dann, wenn die Seriensteuergeräte 101, 102 am Ende des Entwicklungsprozesses vorliegen. Erst in dieser Situation ist es möglich, die Software-Komponenten der realen Steuergeräte 101, 102 im Zusammenspiel mit dem Simulator zu testen. Die I/O-Schnittstellen 107, 108 ermöglichen im vorliegenden Fall auch die Simulation elektrischer Fehler, sie weisen also eine in der Praxis als "failure insertion unit" bezeichnete Elektronik zur Fehleraufschaltung auf.

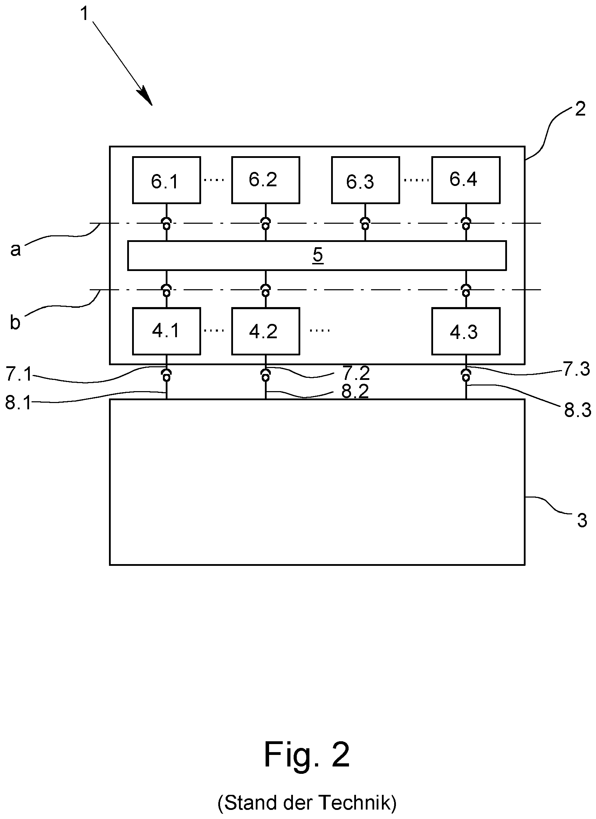

Um auch schon in vorangehenden Schritten der Reglerentwicklung die Komponenten der später auf den realen Steuergeräten 101, 102 zu betreibenden Software zu ermöglichen, sind die in Fig. 2 schematisch dargestellten und aus dem Stand der Technik bekannten Testeinrichtungen 1 eingeführt worden, die den Test eines virtuellen Steuergeräts 2 mit einer Simulationsumgebung 3 ermöglichen. Derartige Testeinrichtungen 1 werden auf einem Simulator betrieben, der in den Figuren 2 bis 7 nicht explizit dargestellt ist.

Das virtuelle Steuergerät 2 umfasst mehrere Software-Komponenten 4, 5, 6, die zu unterschiedlich abstrakten Softwareschichten gehören. Die verschiedenen Softwareschichten sind in Fig. 2 durch waagerechte Linien a, b angedeutet. In dem dargestellten Ausführungsbeispiel sind die Software-Komponenten 6.1, 6.2, 6.3 und 6.4 Komponenten der Applikationsschicht, in der Software vollkommen maschinenunabhängig, also unabhängig von der Zielplattform, implementiert ist. Alle darunter liegenden Softwareschichten sind hardwarenäher. Die Software-Komponente 5 umfasst im dargestellten Ausführungsbeispiel das Runtime-Environment, und die Software-Komponenten 4.1, 4.2 und 4.3 umfassen plattformunabhängige wie auch plattformabhängige Basissoftware, beispielsweise in Form des Betriebssystems und in Form von verschiedenen Kommunikationsdiensten. Bei den Software-Komponenten 4, 5, 6 handelt es sich um Software-Komponenten, die später auf dem realen Steuergerät auch zum Einsatz kommen sollen, die Software-Komponenten werden im Rahmen eines virtuellen Steuergeräts 2 aber auf einem Simulator betrieben, der gerätemäßig vollkommen verschieden von dem späteren realen Steuergerät ist.

Die Software-Komponenten 4 stehen in Verbindung mit der Simulationsumgebung 3. Dazu weisen die Software-Komponenten 4 äußere Datenschnittstellen 7.1, 7.2 und 7.3 auf. Entsprechend weist die Simulationsumgebung Datenschnittstellen 8.1, 8.2. und 8.3 auf. Das in Figur 2 dargestellte virtuelle Steuergerät 2 ist sehr hardwarenah modelliert. Dies ist in der Praxis nicht immer der Fall, in einer anderen Modellierung des virtuellen Steuergeräts 2 könnten beispielsweise nur die Software-Komponenten 6.1 bis 6.4 auf der Applikationsebene vorkommen, so dass ein solches virtuelles Steuergerät über die Software-Komponenten 4 und 5 nicht verfügte. In diesem Fall wären die Schnittstellen der Software-Komponenten 6 die äußeren Datenschnittstellen, weil sie in Verbindung mit der Simulationsumgebung 3 stehen müssten, um einen Datenaustausch gewährleisten zu können. An diesem Beispiel ist erkennbar, dass eine Veränderung des virtuellen Steuergeräts 2 im Stand der Technik eine umfassende Anpassung der Simulationsumgebung 3 nach sich ziehen muss, was entsprechende Nachteile - Softwarepflege, fehlerträchtige Änderungen usw. - mit sich bringt. Im Stand der Technik ist bekannt, im Zusammenhang mit virtuellen Steuergeräten 2 (elektrische) Fehlersimulationen dadurch vorzunehmen, dass die Software-Komponenten 4, 5, 6 in geeigneter Weise geändert werden, also mit entsprechendem Fehlercode instrumentiert werden. Der damit in Zusammenhang stehende Nachteil ist offenkundig, denn es werden nicht mehr die später auch im Serien-Steuergerät verwendeten Software-Komponenten 4, 5, 6 getestet, sondern die abgeänderten, also instrumentierten Software-Komponenten.

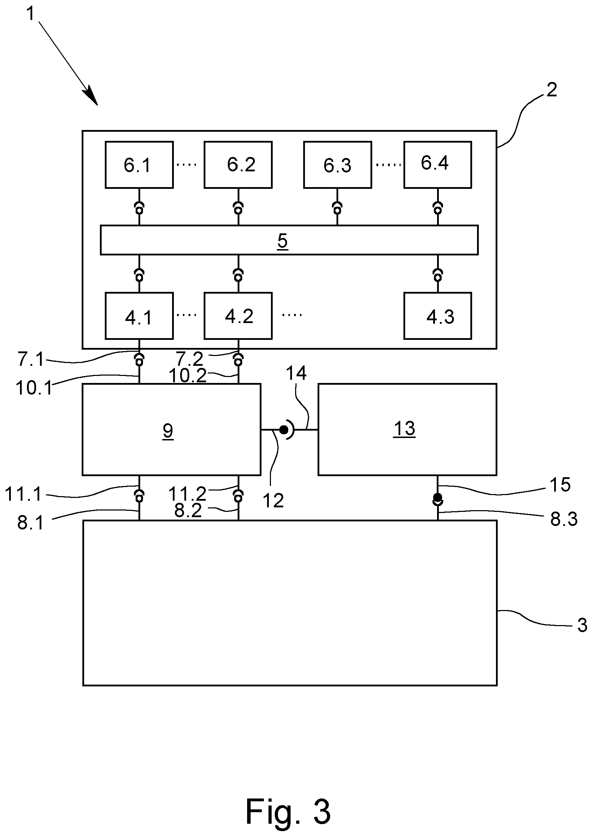

In Fig. 3 ist nun eine erfindungsgemäße Testeinrichtung 1 mit einem virtuellen Steuergerät 2 und mit einer Simulationsumgebung 3 dargestellt, wobei nunmehr aber auch eine zwischen dem virtuellen Steuergerät 2 und der Simulationsumgebung 3 vermittelnde virtuelle Steuergeräte-Pin-Einheit 9 vorgesehen ist. Die virtuelle Steuergeräte-Pin-Einheit 9 weist virtuelle Steuergeräteschnittstellen 10.1, 10.2 auf, mittels derer die virtuelle Steuergeräte-Pin-Einheit 9 mit den äußeren Datenschnittstellen 7.1, 7.2 der Software-Komponenten 4.1, 4.2 des virtuellen Steuergeräts 2 verbunden ist. Die virtuelle Steuergeräte-Pin-Einheit 9 weist ferner Simulationsumgebungsschnittstellen 11.1, 11.2 auf und ist mittels der Simulationsumgebungsschnittstellen 11.1, 11.2 mit den Datenschnittstellen 8.1, 8.2 der Simulationsumgebung 3 verbunden. Da es sich hier sämtlich um auf einem Rechner realisierte Komponenten handelt, sind die Schnittstellen nicht körperlich zu verstehen, sie sind funktional zu verstehen in dem Sinne, dass über die geschaffenen Schnittstellen - wie auch immer - Daten ausgetauscht und verfügbar gemacht werden können.

Die virtuelle Steuergeräte-Pin-Einheit 9 weist ferner einen virtuellen Steuergeräte-Pin 12 auf, der mit einem Pin der physikalischen Schnittstelle eines zu simulierenden realen Steuergeräts korrespondiert. Über den virtuellen Steuergeräte-Pin 12 ist ein virtuelles physikalisches Steuergerätesignal übertragbar. Mit dem virtuellen Steuergeräte-Pin 12 wird also ein Pin einer physikalischen Schnittstelle eines realen Steuergeräts nachgebildet. Demgemäß werden hier in Form von Daten solche Größen übermittelt, die physikalischen Steuergerätesignalen dieses Pins entsprechen. Der virtuelle Steuergeräte-Pin 12 ermöglicht demnach eine Sicht auf das virtuelle Steuergerät 2, die durch die physikalischen Signalformen der realen physikalischen Schnittstellen des nachzuahmenden realen Steuergeräts vorgegeben ist. Wenn beispielsweise eine Temperatur auf der Applikationsebene des virtuellen Steuergeräts 2 in Form der Angabe T = 2 °C gehandhabt wird, dann wird diese gleiche Information über einen virtuellen Steuergeräte-Pin 12 beispielsweise als ein Signal U = 2,35 V ausgegeben. Die virtuelle Steuergeräte-Pin-Einheit 9 ermöglicht jedenfalls die Signalsicht auf das virtuelle Steuergerät 2, wobei diese Signalsicht in unterschiedlicher Weise genutzt werden kann.

Die Testeinrichtung 1 weist ferner eine virtuelle Beeinflussungs-Einheit 13 auf mit einer ersten Schnittstelle 14 und einer zweiten Schnittstelle 15, wobei die virtuelle Beeinflussungs-Einheit 13 mittels der ersten Schnittstelle 14 mit dem virtuellen Steuergeräte-Pin 12 der Steuergeräte-Pin-Einheit 9 verbunden ist. Mit der zweiten Schnittstelle 15 ist die virtuelle Beeinflussungs-Einheit 13 mit der Datenschnittstelle 8.3 der Simulationsumgebung 3 verbunden. Die virtuelle Beeinflussungs-Einheit 13 ist so ausgestaltet, dass sie über die erste Schnittstelle 14 und/oder die zweite Schnittstelle 15 ein beeinflusstes virtuelles physikalisches Steuergerätesignal austauschen, insbesondere ausgeben kann; demnach ist die Datenschnittstelle 8.3 der Simulationsumgebung 3 Pinorientiert und nicht (nur) funktional ausgestaltet. Mit anderen Worten dient die virtuelle Beeinflussungs-Einheit 13 dazu, eine Fehler-Injektion in den Signalpfad einzubringen. Vorteilhaft an der dargestellten Vorgehensweise ist, dass die Konfiguration der elektrischen Fehlersimulation in der virtuellen Beeinflussungs-Einheit 13 in den verschiedenen Stationen des Steuergerätetests verwendet werden kann, unabhängig davon, ob das virtuelle Steuergerät 2 oder ein reales Steuergerät getestet wird.

Die virtuelle Beeinflussungs-Einheit kann auch verbunden sein mit der äußeren Datenschnittstelle 7 des virtuellen Steuergeräts 2, beispielsweise um funktionale Informationen zur Fehlersimulation zu verwenden.

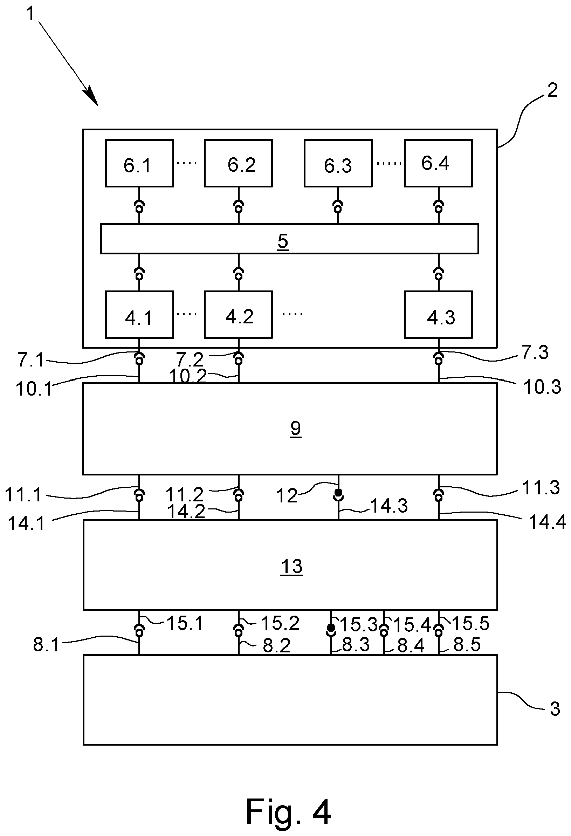

In Fig. 4 ist eine Testeinrichtung 1 dargestellt, bei der das virtuelle Steuergerät 2, die virtuelle Steuergeräte-Pin-Einheit 9, die virtuelle Beeinflussungs-Einheit 13 und die Simulationsumgebung 3 in einer abgewandelten Weise miteinander verbunden sind. In dem Ausführungsbeispiel ist die virtuelle Beeinflussungseinheit 13 der virtuellen Steuergeräte-Pin-Einheit 9 und der Simulationsumgebung 3 zwischengeschaltet, so dass eine mittelbare Verbindung mit der äußeren Datenschnittstelle 7.1, 7.2, 7.3 der Software-Komponenten 4.1, 4.2, 4.3 des virtuellen Steuergeräts 2 besteht. Die virtuelle Steuergeräte-Pin-Einheit 9 ist weiterhin - mittelbar über die virtuelle Beeinflussungs-Einheit 13 - mit der Datenschnittstelle 8 der Simulationsumgebung 3 verbunden. Der Vorteil dieser Variante ist darin zu sehen, dass die virtuelle Beeinflussungs-Einheit 13 nicht nur virtuelle physikalische Steuergerätesignale von der virtuellen Beeinflussungs-Einheit 13 empfängt, sondern vielmehr auch nicht pinbezogene - also rein funktionale - Signale von den Software-Komponenten erhält, die beispielsweise für eine elektrische Fehlersimulation in der virtuellen Beeinflussungs-Einheit 13 verwendet werden können. Die virtuelle Beeinflussungs-Einheit 13 ist in dem Ausführungsbeispiel gemäß Fig. 4 in der Lage, ein beeinflusstes virtuelles physikalisches Steuergerätesignal auf Grundlage von Informationen aus der äußeren Datenschnittstelle 7 der Software-Komponenten 4.1, 4.2, 4.3 des virtuellen Steuergeräts 2 zu berechnen, genauso wie die virtuelle Beeinflussungs-Einheit 13 in der Lage ist, ein beeinflusstes virtuelles physikalisches Steuergerätesignal auf Grundlage von Informationen aus den Teilen der Datenschnittstelle 8 der Simulationsumgebung 3 zu berechnen, die mit der äußeren Datenschnittstelle 7 der Software-Komponenten 4.1, 4.2, 4.3 des virtuellen Steuergeräts 2 korrespondieren.

Die in den Figuren 3 bis 6 dargestellten virtuellen Beeinflussungs-Einheiten 13 sind so ausgestaltet, dass sie ein beeinflusstes virtuelles physikalisches Steuergerätesignal zur Nachbildung eines elektrischen Fehlers an einem beeinflussten virtuellen Steuergeräte-Pin 12 berechnen. Insbesondere ist vorgesehen, dass die virtuellen Beeinflussungs-Einheiten 13 an einem beeinflussten virtuellen Steuergeräte-Pin 12 einen Spannungswert ausgeben, der einem Kurzschluss gegen Masse, Versorgungsspannung oder einem anderen externen elektrischen Potential entspricht. Zur Simulation eines Kurzschlusses zwischen zwei virtuellen Steuergeräte-Pins ist vorgesehen, dass die virtuellen Beeinflussungs-Einheiten 13 auf beiden betroffenen virtuellen Steuergeräte-Pins denselben Spannungswert als beeinflusstes virtuelles Steuergerätesignal ausgeben. Darüber hinaus ist vorgesehen, dass die virtuellen Beeinflussungs-Einheiten 13 für verschiedene virtuelle Steuergeräte-Pins vorgesehene Werte miteinander vertauschen ("crossed wire") und als beeinflusste virtuelle physikalische Steuergerätesignale ausgeben. In einer weiteren implementierten Fehlervariante ist vorgesehen, dass die virtuellen Beeinflussungs-Einheiten 13 einen offenen virtuellen Steuergeräte-Pin simulieren durch Vorgabe eines elektrischen Widerstandswertes an diesem virtuellen Steuergeräte-Pin.

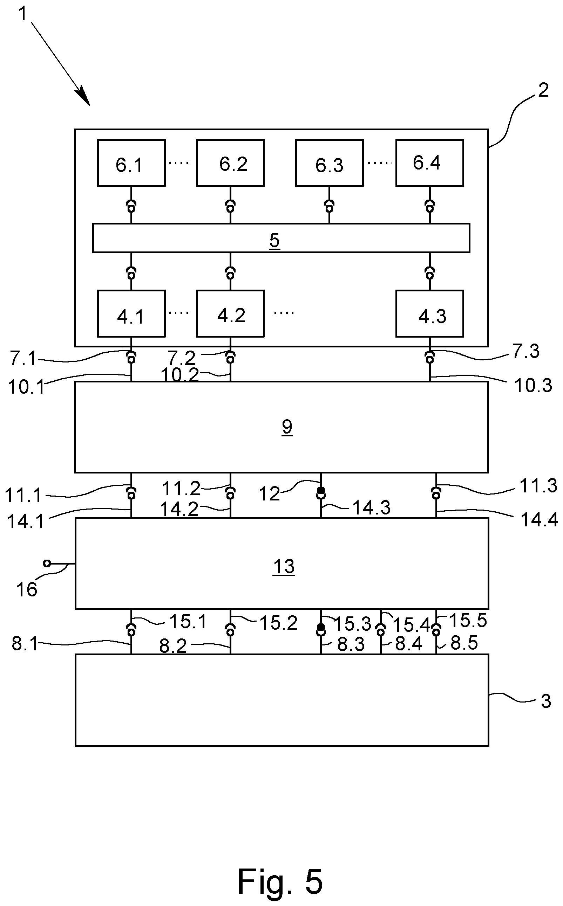

Das Ausführungsbeispiel gemäß Fig. 5 unterscheidet sich von dem Ausführungsbeispiel gemäß Fig. 4 dadurch, dass die virtuelle Beeinflussungs-Einheit 13 eine weitere Schnittstelle 16 aufweist, mittels derer der virtuellen Beeinflussungs-Einheit 13 von extern elektrische Fehlersignale vorgegeben werden können. Diese Fehlersignale können in der Vorgabe fest virtueller elektrischer Potentiale bestehen, es können aber auch veränderliche virtuelle elektrische Fehlersignale in die virtuelle Beeinflussungs-Einheit 13 übermittelt werden.

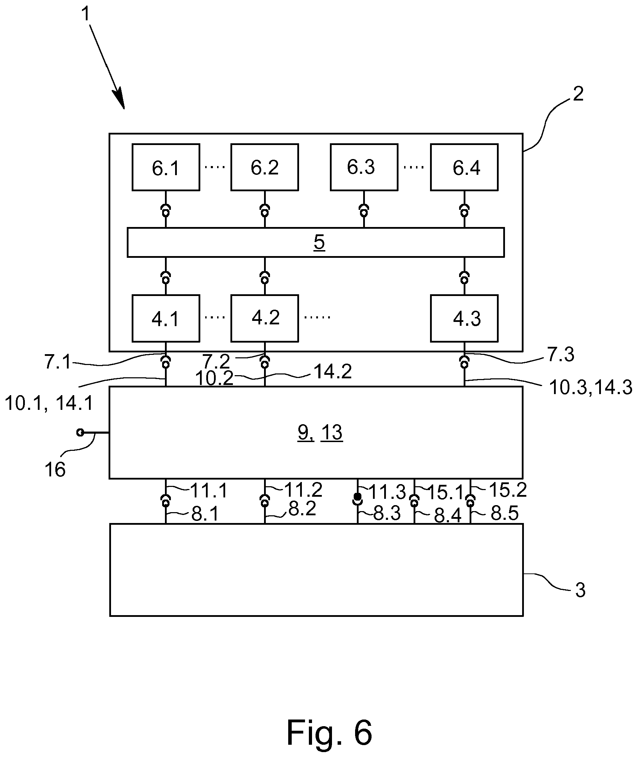

In dem Ausführungsbeispiel gemäß Fig. 6 ist dargestellt, dass die virtuelle Steuergeräte-Pin-Einheit 9 und die virtuelle Beeinflussungs-Einheit 13 in einer gemeinsamen Komponente realisiert sind, der virtuelle Steuergeräte-Pin und die erste Schnittstelle der virtuellen Beeinflussungs-Einheit 13 sind funktional in der gemeinsamen Komponente realisiert. Das Beispiel macht deutlich, dass die verschiedenen Einheiten der Testeinrichtung 1 und ihre Schnittstellen funktional zu verstehen sind und nicht an die Realisierung in getrennten oder gemeinsamen Software-Modulen gebunden sind.

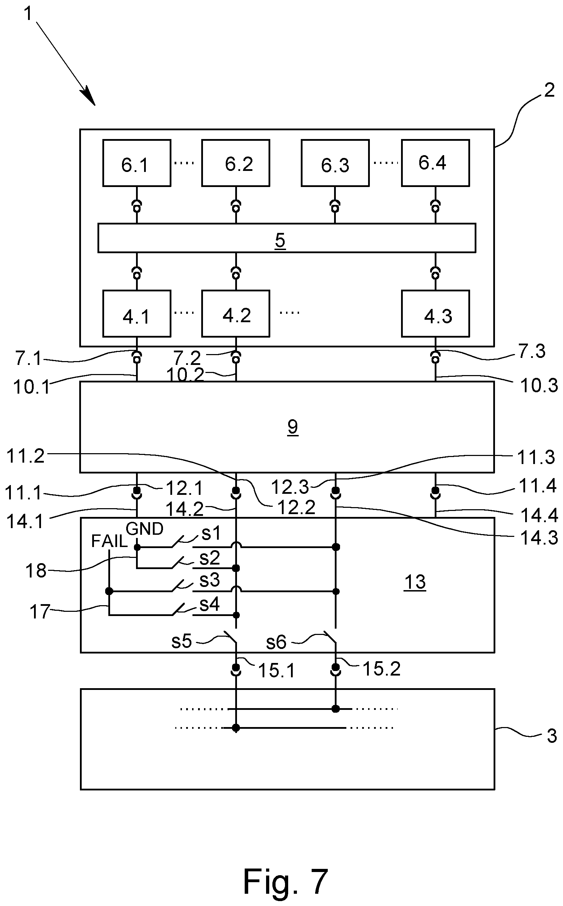

Bei der Testeinrichtung 1 gemäß Fig. 7 ist zunächst bemerkenswert, dass alle dargestellten Kanäle der Simulationsumgebungsschnittstelle 11 der virtuellen Steuergeräte-Pin-Einheit 9 als virtuelle Steuergeräte-Pins 12 realisiert sind, d. h. alle dargestellten Anschlüsse in Richtung auf die Simulationsumgebung 3 der virtuellen Steuergeräte-Pin-Einheit 9 entsprechen einem Pin der physikalischen Schnittstelle des zu simulierenden realen Steuergeräts. Diese Realisierung hat den Vorteil, dass die Simulationsumgebung 3 während des gesamten Reglerentwicklungsprozesses verwendet werden kann, unabhängig von der - gegebenenfalls variierenden - Hardwarenähe der Modellierung des virtuellen Steuergeräts 2. Die durch Veränderung der Modellierung des virtuellen Steuergeräts 2 erforderlichen Anpassungen sind bei der virtuellen Steuergeräte-Pin-Einheit 9 vorzunehmen. Wenngleich auch die virtuelle Steuergeräte-Pin-Einheit 9 angepasst werden muss, ist diese Lösung dennoch vorteilhaft, da die Simulationsumgebung 3 in jedem Fall beim Übergang von dem virtuellen Test zum realen Test in einem HIL-Simulator weiterverwendet werden kann, was anderenfalls nicht möglich wäre. Über die dargestellten Kanäle hinaus können weitere - hier nicht dargestellte - Datenkanäle zwischen der Simulationsumgebung 3 und dem virtuellen Steuergerät 2 realisiert sein, so dass von der Simulationsumgebung 3 auf das virtuelle Steuergerät 2 Einfluss genommen werden kann; diese Datenkanäle und die Anschlüsse, über die diese Datenkanäle geführt werden, haben dann keine Entsprechung zu Datenkanälen und Anschlüssen (Pins) des realen Steuergeräts. Über derartige zusätzliche Datenkanäle könnten beispielsweise Tasks auf dem virtuellen Steuergerät 2 aus der Simulationsumgebung hinaus getriggert werden; dies hängt vom Funktionsumfang der Simulationsumgebung 3 ab.

Ferner ist in Fig. 7 in der virtuellen Beeinflussungs-Einheit 13 symbolisch eine mögliche Realisierung einer Funktionalität dargestellt, die der Aufschaltung eines virtuellen elektrischen Fehlers dient. Bei den Anschlüssen 12.2, 12.3 der virtuellen Steuergeräte-Pin-Einheit 9 handelt es sich um virtuelle Steuergeräte-Pins 12 eines CAN-Busses. Diese Anschlüsse werden symbolisch durch die virtuelle Beeinflussungs-Einheit 13 durchgeschliffen und über die Anschlüsse 15.1, 15.2 der zweiten Schnittstelle der virtuellen Beeinflussungs-Einheit 13 an die Simulationsumgebung 3 weitergegeben. Die Simulationsumgebung 3 weist ebenfalls symbolisch die Leitungen des virtuellen CAN-Busses auf. Die virtuelle Beeinflussung-Einheit 13 weist virtuelle elektrische Fehlerleitungen 17, 18 auf, wobei die virtuellen elektrischen Fehlerleitungen 17, 18 mit Anschlüssen der ersten Schnittstelle 14 und/oder mit Anschlüssen der zweiten Schnittstelle 15 verbindbar sind. Die Verbindbarkeit wird realisiert durch die Schalter s1 bis s6. Das in Figur 7 dargestellte Schaltnetzwerk gibt funktional und anschaulich die Möglichkeit der Fehleraufschaltung in der virtuellen Beeinflussungs-Einheit 13 wieder. Diese Funktionalität ist tatsächlich in Software realisiert, so dass Schalter und Anschlussstellen durch Variablen abgebildet werden, wobei diesen Variablen zugeordnete Werte zu einer entsprechenden Zuordnung von Fehlersignalen auf Knotenstellen des Netzwerks führen. Im vorliegenden Fall sind die virtuellen elektrischen Fehlerleitungen 17, 18 mit virtuellen physikalischen Größen beaufschlagt, vorliegend mit den elektrischen Potentialen GND und FAIL.

In anderen Ausführungsbeispielen handelt es sich bei den virtuellen physikalischen Größen um elektrische Ströme oder um elektrische Widerstände. Die Idee besteht jedenfalls immer darin, dass die beaufschlagte virtuelle physikalische Größe auch als Vorgabe für die verbundenen Anschlüsse der ersten Schnittstelle 14 und/oder für die verbundenen Anschlüsse der zweiten Schnittstelle 15 wirken. Wie bereits erwähnt, muss es sich dabei nicht nur um statische virtuelle physikalische Größen handeln, vielmehr kann es sich auch um zeitveränderliche virtuelle physikalische Größen handeln.

Vorteilhafterweise ist die virtuelle Steuergeräte-Pin-Einheit 13 so ausgebildet, dass sie Programmcode zur Beeinflussung der virtuellen Steuergerätesignale und/oder zur Ermittlung der virtuellen Steuergerätesignale generiert. Dies ermöglicht, dass der Programmcode nicht vom Verwender der Testeinrichtung vorgegeben werden muss, sondern dass eine mögliche Funktionalität zur Fehlersimulation beispielsweise durch einen graphischen Editor modelliert werden kann - zum Beispiel in Form eines wie in Figur 7 dargestellten Schaltnetzwerkes - so dass der potentiell fehlerträchtige Schritt der Übertragung der Funktionalität in Programmcode durch den Verwender der Testeinrichtung entfällt. Vorzugsweise ist vorgesehen, dass zumindest der Programmcode des virtuellen Steuergeräts 2, der Programmcode der Simulationsumgebung 3 und der von dem virtuellen Steuergerät 2 generierte Programmcode in einer gemeinsamen Simulation ausgeführt werden, wobei die Simulation insbesondere eine Echtzeitsimulation ist.

## Patentansprüche

1. Testeinrichtung (1) zum Test zumindest eines Teils eines virtuellen Steuergeräts (2) mit einem Simulator, aufweisend eine Simulationsumgebung (3), die Testeinrichtung (1) aufweisend das virtuelle Steuergerät (2) und die Simulationsumgebung (3), wobei das virtuelle Steuergerät (2) wenigstens eine Software-Komponente (4, 5, 6) mit wenigstens einer äußeren Datenschnittstelle (7) umfasst, wobei die Simulationsumgebung (3) wenigstens eine Datenschnittstelle (8) zum zumindest mittelbaren Datenaustausch mit dem virtuellen Steuergerät (2) umfasst,
**dadurch gekennzeichnet,**
**dass** eine virtuelle Steuergeräte-Pin-Einheit (9) wenigstens eine virtuelle Steuergeräteschnittstelle (10) aufweist und mittels der virtuellen Steuergeräteschnittstelle (10) zumindest mit der äußeren Datenschnittstelle (7) der Software-Komponente (4) des virtuellen Steuergeräts (2) verbunden ist,
**dass** die virtuelle Steuergeräte-Pin-Einheit (9) wenigstens eine Simulationsumgebungsschnittstelle (11) aufweist und mittels der Simulationsumgebungsschnittstelle zumindest mittelbar mit der Datenschnittstelle (8) der Simulationsumgebung (3) verbunden ist,
**dass** die virtuelle Steuergeräte-Pin-Einheit (9) wenigstens einen virtuellen Steuergeräte-Pin (12) aufweist, der mit einem Pin der physikalischen Schnittstelle eines zu simulierenden realen Steuergeräts korrespondiert, wobei über den virtuellen Steuergeräte-Pin (12) ein virtuelles physikalisches Steuergerätesignal übertragbar ist, das in Datenform die physikalischen Steuergerätesignale an dem korrespondierenden Pin der physikalischen Schnittstelle beschreibt, und
**dass** eine virtuelle Beeinflussungs-Einheit (13) wenigstens eine erste Schnittstelle (14) und eine zweite Schnittstelle (15) aufweist und mittels der ersten Schnittstelle (14) zumindest mit dem virtuellen Steuergeräte-Pin (12) der Steuergeräte-Pin-Einheit (9) verbunden ist und mit der zweiten Schnittstelle (15) mit der Datenschnittstelle (8) der Simulationsumgebung (3) verbunden ist, wobei die virtuelle Beeinflussungs-Einheit (13) über die erste Schnittstelle (14) und/oder die zweite Schnittstelle (15) ein beeinflusstes virtuelles physikalisches Steuergerätesignal ausgibt.

2. Testeinrichtung (1) nach Anspruch 1, **dadurch gekennzeichnet, dass** die Beeinflussungs-Einheit (13) ein beeinflusstes virtuelles physikalisches Steuergerätesignal selbständig bereitstellt, insbesondere ohne Informationen aus der Simulationsumgebung (3), und über die erste Schnittstelle (14) an die virtuelle Steuergeräte-Pin-Einheit (9) überträgt.

3. Testeinrichtung (1) nach Anspruch 1 oder 2, **dadurch gekennzeichnet, dass** die Beeinflussungs-Einheit (13) auf Grundlage von Informationen aus der Simulationsumgebung (3) ein beeinflusstes virtuelles physikalisches Steuergerätesignal berechnet, und über die erste Schnittstelle (14) an die virtuelle Steuergeräte-Pin-Einheit (9) überträgt.

4. Testeinrichtung (1) nach einem der Ansprüche 1 bis 3, **dadurch gekennzeichnet, dass** die virtuelle Beeinflussungs-Einheit (13) von der virtuellen Steuergeräte-Pin-Einheit (9) ein virtuelles physikalisches Steuergerätesignal empfängt und aus dem empfangenen virtuellen physikalischen Steuergerätesignal ein beeinflusstes virtuelles physikalisches Steuergerätesignal berechnet, insbesondere das beeinflusste virtuelle physikalische Steuergerätesignal über die zweite Schnittstelle (15) an die Simulationsumgebung (3) ausgibt.

5. Testeinrichtung (1) nach einem der Ansprüche 1 bis 4, **dadurch gekennzeichnet, dass** die virtuelle Beeinflussungs-Einheit (13) der virtuellen Steuergeräte-Pin-Einheit (9) und der Simulationsumgebung (3) zwischengeschaltet ist, so dass eine mittelbare Verbindung mit der äußeren Datenschnittstelle (7) der Software-Komponente (4, 5, 6) des virtuellen Steuergeräts (2) besteht und/oder so dass eine Verbindung mit den Teilen der Datenschnittstelle (8) der Simulationsumgebung (3) hergestellt ist, die mit der äußeren Datenschnittstelle (7) der Software-Komponente (4, 5, 6) des virtuellen Steuergeräts (2) korrespondieren.

6. Testeinrichtung nach Anspruch 5, **dadurch gekennzeichnet, dass** die virtuelle Beeinflussungs-Einheit (13) ein beeinflusstes virtuelles physikalisches Steuergerätesignal berechnet auf Grundlage von Informationen aus der äußeren Datenschnittstelle (7) der Software-Komponente (4, 5, 6) des virtuellen Steuergeräts (2) und/oder
auf Grundlage von Informationen aus den Teilen der Datenschnittstelle (8) der Simulationsumgebung (3), die mit der äußeren Datenschnittstelle (7) der Software-Komponente (4, 5, 6) des virtuellen Steuergeräts (2) korrespondieren.

7. Testeinrichtung (1) nach einem der Ansprüche 1 bis 6, **dadurch gekennzeichnet, dass** die virtuelle Beeinflussungs-Einheit (13) ein beeinflusstes virtuelles physikalisches Steuergerätesignal zu Nachbildung eines elektrischen Fehlers an einem beeinflussten virtuellen Steuergeräte-Pin (12) berechnet,
insbesondere an einem beeinflussten virtuellen Steuergeräte-Pin einen Spannungswert ausgibt, der einem Kurzschluss gegen Masse, Versorgungsspannung oder einen anderen externen elektrischen Potential entspricht, und/oder
insbesondere zur Simulation eines Kurzschlusses zwischen zwei virtuellen Steuergeräte-Pins auf beiden betroffenen virtuellen Steuergeräte-Pins denselben Spannungswert als beeinflusstes virtuelles Steuergerätesignal ausgibt, und/oder
insbesondere für verschiedene virtuelle Steuergeräte-Pins vorgesehene Werte miteinander vertauscht und als beeinflusste virtuelle physikalische Steuergerätesignale ausgibt,
insbesondere einen offenen virtuellen Steuergeräte-Pin durch Vorgabe eines elektrischen Widerstandswertes an diesem virtuellen Steuergeräte-Pin simuliert.

8. Testeinrichtung nach einem der Ansprüche 1 bis 7, **dadurch gekennzeichnet, dass** die virtuelle Beeinflussungs-Einheit (13) wenigstens eine virtuelle elektrische Fehlerleitung (17, 18) aufweist, wobei die virtuelle elektrische Fehlerleitung (17, 18) mit Anschlüssen der ersten Schnittstelle (14) und/oder mit Anschlüssen der zweiten Schnittstelle (15) verbindbar ist.

9. Testeinrichtung nach Anspruch 8, **dadurch gekennzeichnet, dass** die virtuelle elektrische Fehlerleitung (17, 18) mit einer virtuellen physikalischen Größe beaufschlagbar ist, insbesondere mit einer elektrischen Spannung, einem elektrischen Strom oder einem elektrischen Widerstand, so dass die beaufschlagte virtuelle physikalische Größe auch als Vorgabe für die verbundenen Anschlüsse der ersten Schnittstelle (14) und/oder für die verbundenen Anschlüsse der zweiten Schnittstelle (15) wirkt, insbesondere wobei es sich bei der virtuellen physikalischen Größe auch um einen zeitlichen Signalverlauf der Größe handeln kann.

10. Testeinrichtung (1) nach Anspruch 9, **dadurch gekennzeichnet, dass** die virtuelle physikalische Größe, mit der die virtuelle elektrische Fehlerleitung (17, 18) beaufschlagt ist, von extern der virtuellen Beeinflussungs-Einheit (13) vorgebbar ist und/oder von der virtuellen Beeinflussungs-Einheit (13) berechnet wird.

11. Testeinrichtung nach einem der Ansprüche 1 bis 10, **dadurch gekennzeichnet, dass** in der virtuellen Steuergeräte-Pin-Einheit (9) Programmcode generiert wird zur Beeinflussung der virtuellen Steuergerätesignale und/oder zur Ermittlung der virtuellen Steuergerätesignale.

12. Testeinrichtung (1) nach einem der Ansprüche 1 bis 11, **dadurch gekennzeichnet, dass** zumindest der Programmcode des virtuellen Steuergeräts (2), der Programmcode der Simulationsumgebung (3) und der von dem virtuellen Steuergerät (2) generierte Programmcode in einer gemeinsamen Simulation ausgeführt werden, wobei die Simulation insbesondere eine Echtzeitsimulation ist.

## Claims

1. A test device (1) for testing at least one part of a virtual control device (2) having a simulation environment (3) by means of a simulator, the test device (1) comprising the virtual control device (2) and the simulation environment (3), the virtual control device (2) comprising at least one software component (4, 5, 6) comprising at least one external data interface (7), the simulation environment (3) comprising at least one data interface (8) for exchanging data at least indirectly with the virtual control device (2),
**characterized in that,**
a virtual control device pin unit (9) comprises at least one virtual control device interface (10) and is connected at least to the external data interface (7) of the software component (4) of the virtual control device (2) by means of the virtual control device interface (10),
that the virtual control device pin unit (9) comprises at least one simulation environment interface (11) and is connected at least indirectly to the data interface (8) of the simulation environment (3) by means of the simulation environment interface, and
that the virtual control device pin unit (9) comprises at least one virtual control device pin (12) corresponding to a pin of the physical interface of a real control device to be simulated, wherein a virtual physical control device signal describing in data form the value of a physical control device signal of a pin of a physical interface that can be transmitted via the virtual control device pin (12), and
that a virtual influencing unit (13) comprises at least one first interface (14) and one second interface (15) and is connected at least to the virtual control device pin (12) of the control device pin unit (9) by means of the first interface (14) and to data interface (8) of the simulation environment (3) by means of the second interface (15), wherein the virtual influencing unit (13) outputs an influenced virtual physical control device signal via the first interface (14) and/or the second interface (15) .

2. The test device (1) according to claim 1, **characterized in that** the influencing unit (13) independently provides an influenced virtual physical control device signal, particularly without information from the simulation environment (3), and transfers said signal to the virtual control device pin unit (9) via the first interface (14).

3. The test device (1) according to claim 1 or 2, **characterized in that** the influencing unit (13) calculates an influenced virtual physical control device signal on the basis of information from the simulation environment (3) and transfers said signal to the virtual control device pin unit (9) via the first interface (14).

4. The test device (1) according to any one of the claims 1 through 3, **characterized in that** the virtual influencing unit (13) receives a virtual physical control device signal from the virtual control device pin unit (9) and calculates an influenced virtual physical control device signal from the received virtual physical control device signal, particularly outputting the influenced virtual physical control device signal to the simulation environment (3) via the second interface (15).

5. The test device (1) according to any one of the claims 1 through 4, **characterized in that** the virtual influencing unit (13) is connected between the virtual control device pin unit (9) and the simulation environment (3), so that a direct connection exists to the external data interface (7) of the software component (4, 5, 6) of the virtual control device (2), and/or so that a connection is produced to the parts of the data interface (8) of the simulation environment (3) corresponding to the external data interface (7) of the software components (4, 5, 6) of the virtual control device (2).

6. The test device according to claim 5, **characterized in that** the virtual influencing unit (13) calculates an influenced virtual physical control device signal on the basis of information from the external data interface (7) of the software component (4, 5, 6) of the virtual control device (2), and/or on the basis of information from the parts of the data interface (8) of the simulation environment (3) corresponding to the external data interface (7) of the software components (4, 5, 6) of the virtual control device (2).

7. The test device (1) according to any one of the claims 1 through 6, **characterized in that** the virtual influencing unit (13) calculates an influenced virtual physical control device signal for recreating an electrical defect on an influenced virtual control device pin (12),
particularly on an influenced virtual control device pin outputting a voltage value corresponding to a short circuit to ground, supply voltage, or a different external electrical potential, and/or
particularly for simulating a short circuit between two virtual control device pins on both affected virtual control device pins having the same voltage value as the influenced virtual control device signal, and/or
particularly mutually exchanges values intended for various virtual control device pins and outputs said values as an influenced virtual physical control device signals, particularly an open virtual control device pin by specifying an electrical resistance value on said virtual control device pin.

8. A test device according to any one of the claims 1 through 7, **characterized in that** the virtual influencing unit (13) comprises at least one virtual electrical fault conductor (17, 18), wherein the virtual electrical fault conductor (17, 18) can be connected to connections of the first interface (14) and/or to connections of the second interface (15).

9. The test device according to claim 8, **characterized in that** a virtual physical parameter can be applied to the virtual electrical fault conductor (17, 18), particularly an electrical voltage, an electrical current, or an electrical resistance, so that the applied virtual physical parameter also acts as a specification for the connected connections of the first interface (14) and/or for the connected connections of the second interface (15), particularly wherein the virtual physical parameter can also be a time-based signal path of the variable.

10. The test device (1) according to claim 9, **characterized in that** the virtual physical parameter applied to the virtual electrical fault conductor (17, 18) can be defined externally to the virtual influencing unit (13) and/or is calculated by the virtual influencing unit (13).

11. The test device according to any one of the claims 1 through 10, **characterized in that** program code is generated in the virtual control device pin unit (9) for influencing the virtual control device signals and/or for detecting the virtual control device signals.

12. The test device (1) according to any one of the claims 1 through 11, **characterized in that** at least the program code of the virtual control device (2), the program code of the simulation environment (3), and the program code generated by the virtual control device (2) are executed in a joint simulation, wherein the simulation is particularly a real-time simulation.

## Revendications

1. Dispositif de test (1) pour tester au moins une partie d'un appareil de commande fictif (2) avec un simulateur, comportant un environnement de simulation (3), le dispositif de test (1) comportant l'appareil de commande fictif (2) et l'environnement de simulation (3), dans lequel l'appareil de commande fictif (2) comporte au moins une composante de logiciel (4, 5, 6) avec au moine une interface de données externe (7), dans lequel l'environnement de simulation (3) comporte au moins une interface de données (8) pour au moins l'échange de données indirecte avec l'appareil de commande fictif (2),
**caractérisé en ce que**
une unité de broche d'appareil de commande fictive (9) comporte au moins une interface d'appareil de commande fictive (10) et elle est reliée avec au moins l'interface de données externe (7) de la composante de logiciel (4) de l'appareil de commande fictif (2) via l'interface d'appareil de commande fictive (10),
l'unité de broche d'appareil de commande fictive (9) comporte au moine une interface d'environnement de simulation (11) et elle est reliée au moins indirectement avec l'interface de données (8) de l'environnement de simulation (3) via l'interface d'environnement de simulation,
l'unité de broche d'appareil de commande fictive (9) comporte au moins une broche d'appareil de commande fictive (12), qui correspond à une broche de l'interface physique d'un appareil de commande réel devant être simulé, sachant qu'il est transmissible, via la broche d'appareil de commande fictive (12), un signal d'appareil de commande physique fictif qui, sous forme de données, décrit les signaux d'appareil de commande physique à la broche correspondante de l'interface physique, et
une unité d'influence fictive (13) comporte au moins une première interface (14) et une seconde interface (15) et est reliée via la première interface (14) avec au moins la broche d'appareil de commande fictive (12) de l'unité de broche d'appareil de commande fictive (9) et est reliée via la seconde interface (15) avec l'interface de données (8) de l'environnement de simulation (3), sachant que l'unité d'influence fictive (13) émet via la première interface (14) et/ou la seconde interface (15) un signal d'appareil de commande fictif physique influencé.

2. Dispositif de test (1) selon la revendication 1, **caractérisé en ce que** l'unité d'influence (13) met à disposition automatiquement un signal d'appareil de commande fictif physique influencé, en particulier sans informations provenant de l'environnement de simulation (3), et le transmet via la première interface (14) à l'unité de broche d'appareil de commande fictive (9) .

3. Dispositif de test (1) selon la revendication 1 ou 2, **caractérisé en ce que** l'unité d'influence (13) calcule sur la base d'informations provenant de l'environnement de simulation (3) un signal d'appareil de commande fictif physique influencé, et le transmet via la première interface (14) à l'unité de broche d'appareil de commande fictive (9).

4. Dispositif de test (1) selon l'une des revendications 1 à 3, **caractérisé en ce que** l'unité d'influence fictive (13) reçoit de l'unité de broche d'appareil de commande fictive (9) un signal d'appareil de commande fictif physique et, à partir du signal d'appareil de commande fictif physique reçu, calcule un signal d'appareil de commande fictif physique influencé, en particulier, délivre le signal d'appareil de commande fictif physique influencé à l'environnement de simulation (3) via la seconde interface (15) .

5. Dispositif de test (1) selon l'une des revendications 1 à 4, **caractérisé en ce que** l'unité d'influence fictive (13) est intercalée entre l'unité de broche d'appareil de commande fictive (9) et l'environnement de simulation (3), de sorte qu'il existe une liaison indirecte avec l'interface de données externe (7) de la composante de logiciel (4, 5, 6) de l'appareil de commande fictif (2) et/ou de sorte qu'il soit établi une liaison avec les parties de l'interface de donnée (8) de l'environnement de simulation (3) qui correspondent avec l'interface de données externe (7) de la composante de logiciel (4, 5, 6) de l'appareil de commande fictif (2) .

6. Dispositif de test selon la revendication 5, **caractérisé en ce que** l'unité d'influence fictive (13) calcul un signal d'appareil de commande fictif physique influencé sur la base d'informations provenant de l'interface de données externe (7) de la composante de logiciel (4, 5, 6) de l'appareil de commande fictif (2) et/ou sur la base d'informations provenant des parties de l'interface de données (8) de l'environnement de simulation (3), qui correspondent avec l'interface de données externe (7) de la composante de logiciel (4, 5, 6) de l'appareil de commande fictif (2) .

7. Dispositif de test (1) selon l'une des revendications 1 à 6, **caractérisé en ce que** l'unité d'influence fictive (13) calcule un signal d'appareil de commande fictif physique influencé en vue de l'émulation d'une erreur électrique sur une broche d'appareil de commande fictive influencée (12),
en particulier, délivre sur une broche d'appareil de commande fictive influencée une valeur de tension qui correspond à un court-circuit à la masse, à la tension d'alimentation ou un autre potentiel électrique externe, et/ou
en particulier, en vue de la simulation d'un court-circuit entre deux broches d'appareil de commande fictives, délivre sur les deux broches d'appareil de commande fictives concernées la même valeur de tension en tant que signal d'appareil de commande fictif influencé, et/ou
en particulier, échange les unes avec les autres des valeurs prévues pour des broches d'appareil de commande fictives différentes et les délivre en tant que signaux d'appareil de commande fictifs physiques influencés,
en particulier, simule une broche d'appareil de commande fictive ouverte en allouant une valeur de résistance électrique sur cette broche d'appareil de commande fictive.

8. Dispositif de test selon l'une des revendications 1 à 7, **caractérisé en ce que** l'unité d'influence fictive (13) comporte au moins une ligne de défaut électrique fictive (17, 18), sachant que la ligne de défaut électrique fictive (17, 18) peut être reliée avec des raccords de la première interface (14) et/ou avec des raccords de la seconde interface (15).

9. Dispositif de test selon la revendication 8, **caractérisé en ce que** la ligne de défaut électrique fictive (17, 18) peut être soumise à une grandeur physique fictive, en particulier à une tension électrique, un courant électrique ou une résistance électrique, de sorte que la grandeur physique fictive appliquée agissent également en tant que valeur allouée pour les raccords reliés de la première interface (14) et/ou les raccords reliés de la seconde interface (15), sachant en particulier que la grandeur physique fictive peut également être une évolution de signal de la grandeur dans le temps.

10. Dispositif de test (1) selon la revendication 9, **caractérisé en ce que** la grandeur physique fictive à laquelle est soumise la ligne de défaut électrique fictive (17, 18), peut être allouée de manière externe à l'unité d'influence fictive (13) et/ou être calculée par l'unité d'influence fictive (13).

11. Dispositif de test selon l'une des revendications 1 à 10, **caractérisé en ce qu'**un code de programme est généré dans l'unité de broche d'appareil de commande fictive (9) en vue d'influencer les signaux d'appareil de commande fictifs et/ou de déterminer les signaux d'appareil de commande fictifs.

12. Dispositif de test (1) selon l'une des revendications 1 à 11, **caractérisé en ce qu'**au moins le code de programme de l'appareil de commande fictif (2), le code de programme de l'environnement de simulation (3) et le code de programme généré par l'appareil de commande fictif (2) sont exécutés dans une simulation commune, sachant que la simulation est en particulier une simulation en temps réel.
